# EUROPÄISCHE PATENTSCHRIFT

(11) **EP 0 424 747 B1**
(45) Veröffentlichungstag und Bekanntmachung des Hinweises auf die Patenterteilung: **06.09.1995**
(21) Anmeldenummer: 90119556.0
(22) Anmeldetag: 12.10.1990
(51) Int. Cl.: H05K 7/18, H05K 5/00

(54) **Verbindung zweier Gehäuseteile insbesondere des Sockels eines Kabelverteilerschrankes mit dessen Aufbau**
Joining device for two cabinet parts in particular for base of cable distribution cabinet with the same
Dispositif de liaison de deux pièces d'armoire en particulier du socle d'une armoire de distribution de câbles avec celle-ci

(30) Priorität: 21.10.1989 DE 3935158
(43) Veröffentlichungstag der Anmeldung: 02.05.1991
(73) Patentinhaber: Jean Müller GmbH Elektrotechnische Fabrik, D-65343 Eltville (DE)
(72) Erfinder: Müller, Markus, Dipl.-Ing., W-6228 Eltville am Rh. 1 (DE)
(74) Vertreter: Quermann, Helmut, Dipl.-Ing.

(56) Entgegenhaltungen:
- DE-A- 3 135 899
- DE-U- 8 710 424

## Beschreibung

Die Erfindung betrifft eine Verbindung zweier Gehäuseteile, insbesondere des Sockels eines Kabelverteilerschrankes mit dessen Aufbau, mit im Inneren der Gehäuseteile angeordneten Verbindungselementen.

Es sind Kabelverteilerschränke aus der Praxis bekannt, bei denen Aufbau und Sockel separate Bauteile darstellen, die miteinander verbunden sind. Der Sockel ruht auf dem Erdboden bzw. ist teilweise in den Boden eingegraben, der Aufbau weist Türen auf, so daß die im Aufbau untergebrachten Verteilerelemente zugänglich sind. Um den Aufbau mit dem Sockel verbinden zu können, ist es bekannt, Sockel und Aufbau auf den einander zugewandten Seiten jeweils mit einem nach innen gerichten, umlaufenden Rand zu versehen, wobei die Ränder miteinander korrespondierende Aufnehmungen aufweisen, durch die Verbindungselemente, beispielsweise Schrauben gesteckt und mit Muttern gesichert werden können. Nachteilig ist bei einer derartigen Ausbildung der Verbindung von Sockel und Aufbau des Kabelverteilerschrankes, daß die Ränder nur aufwendig hergestellt werden können und außerdem der lichte Querschnitt des Kabelverteilerschrankes im Übergang vom Sockel zum Aufbau reduziert ist, was sich negativ auf die Kabeldurchführung in den Aufbau auswirkt. Im übrigen wird es als nachteilig angesehen, daß durch die starre Verbindung zwischen Aufbau und Sockel die Gefahr besteht, daß bei einer gewaltsamen Einwirkung auf den Aufbau auch der Sockel beschädigt wird. Der gesamte Kabelverteilerschrank muß gegebenenfalls ersetzt werden, was gerade dann, wenn der Sockel in den Erdboden eingegraben ist, mit erheblichem Aufwand verbunden ist.

Es ist Aufgabe der vorliegenden Erfindung, eine einfach herstell- und montierbare Verbindung zwischen zwei Gehäuseteilen zu schaffen.

Gelöst wird die Aufgabe dadurch, daß die Verbindungselemente im wesentlichen aus einem in einem der Gehäuseteile gelagerten und in das andere Gehäuseteil einsteckbaren Steckelement mit mindestens einer Keilaufnahme, sowie mindestens einem im anderen Gehäuseteil relativ zu dem Steckelement verschiebbaren Arretierkeil, der in seiner arretierten Stellung die mindestens eine Keilaufnahme hintergreift, bestehen.

Die Erfindung schlägt damit eine einfache Steckverbindung zum Verbinden der beiden Gehäuseteile vor. Das mit dem einen Gehäuseteil verbundene Steckelement wird in das andere Gehäuseteil eingesteckt und anschließend der Arretierkeil aus der nicht arretierten Stellung in die arretierte Stellung bewegt, in der er die steckelementseitige Keilaufnahme hintergreift. Um ein Aufgleiten des Arretierkeiles auf die Keilaufnahme zu erleichtern, ist die Keilaufnahme vorteilhaft auf der dem Arretierkeil zugewandten Seite nach außen gewölbt ausgebildet. Die Erfindung ist nicht darauf beschränkt, daß das Steckelement eine einzige Keilaufnahme aufweist, die mit einem einzigen Arretierkeil zusammenwirkt, es werden vielmehr jeweils zwei Keilaufnahmen und Arretierkeile als vorteilhaft erachtet, gegebenenfalls können es auch mehr sein. Gerade zwei Keilaufnahmen bzw. zwei Arretierkeile bieten aber bei einer beabstandeten Anordnung eine ausreichende Gewähr dafür, daß in die Gehäuseteile eingeleitete Kippmomente von diesen sicher aufgenommen werden können.

Zweckmäßig ist jedes Gehäuseteil im Bereich der gegenüberliegenden schmalseitigen Gehäusewandungen mit einem oder mehreren Steckelementen bzw. Arretierkeilen versehen. Zu einer befriedigenden Befestigung der Gehäuseteile ist es damit nicht notwendig, daß die Gehäuseteile im Bereich aller Wandungen miteinander verbunden werden.

Gemäß einer besonderen Ausführungsform der Erfindung ist vorgesehen, daß das Steckelement in einer Gehäusewandung des einen Gehäuseteils in der Wandungsebene in Richtung des anderen Gehäuseteils in Führungen verschiebbar gelagert ist und auf seiner dem anderen Gehäuseteil zugewandten Seite mit der mindestens einen Keilaufnahme versehen ist, und daß der Arretierkeil in der angrenzenden Gehäusewandung des anderen Gehäuseteils in der Wandungsebene senkrecht zur Bewegungsrichtung des Steckelements in Führungen verschiebbar gelagert ist. Es ergibt sich hierdurch eine baulich einfache verschiebliche Lagerung von Steckelement und Keilaufnahme, die zudem nur eine geringe Bautiefe aufweist, das heißt nur geringfügig den lichten Querschnitt des Durchganges zwischen den beiden Gehäuseteilen verringert. Eine Weiterbildung sieht in diesem Zusammenhang vor, daß die mindestens eine Keilaufnahme in einer ersten Endstellung des Steckelements sich außerhalb des Bewegungsweges des zugeordneten Arretierkeils befindet und in einer zweiten Endstellung, bei Anlage des Steckelements an einem dessen Gehäuseteil zugeordneten Anschlages, im Bewegungsweg des zugeordneten Arretierkeils. In der zweiten Endstellung ergibt sich damit einerseits zwischen dem dem einen Gehäuseteil zugeordneten Anschlag und dem Steckelement eine formschlüssige Verbindung, andererseits zwischen der Keilaufnahme und dem Arretierkeil, damit eine kraftschlüssige Verbindung zwischen den beiden Gehäuseteilen.

Vorteilhaft wird der mindestens eine Arretierkeil von einer Trägerplatte aufgenommen, die in Anlage mit der zugeordneten Wandung des Gehäuseteils zwischen zwei sich in Verschieberichtung der Trägerplatte seitlich zu dieser erstreckenden Lagerplatten gehalten ist. Die Lagerplatten sollten Bestandteil des dem Arretierkeil zugeordneten Gehäuseteils bilden und die dem Steckelement zugeordnete Lagerplatte mindestens eine Ausnehmung zur Aufnahme der mindestens einen Keilaufnahme des Steckelements aufweisen. Es wird überdies als vorteilhaft erachtet, wenn eine Abdeckplatte für die Trägerplatte vorgesehen ist, die mit dem der Trägerplatte zugeordneten Gehäuseteil oder einer oder beiden Lagerplatten verbunden ist, wobei die Abdeckplatte in Verschieberichtung der Trägerplatte mit einer schlitzförmigen Ausnehmung versehen sein sollte, die ein mit der Trägerplatte verbundener Betätigungszapfen durchsetzt. Mittels dieses Betätigungszapfens kann die Trägerplatte einfach gehandhabt werden und damit auch der mindestens eine der Trägerplatte zugeordnete Arretierkeil zum Verbinden des Steckelementes mit dem anderen Gehäuseteil. Um das Steckelement handhaben zu können, sollte es auf seiner der mindestens einen Keilaufnahme abgewandten Seite mit einer Grifflasche versehen sein.

Eine besondere Ausführungsform der Erfindung sieht in diesem Zusammenhang vor, daß das Steckelement zwischen seinem mit dem Anschlag in Anlage gelangenden Bereich und der mindestens einen Keilaufnahme mit einer Sollbruchstelle versehen ist. Es ist hierdurch gewährleistet, daß bei einer Einwirkung einer Bruchkraft auf eines der beiden Gehäuseteile, insbesondere das dem Steckelement zugeordnete Gehäuseteil, die Verbindung der beiden Gehäuseteile im Bereich der Sollbruchstelle bricht. Im Ergebnis ist es demzufolge nur notwendig, nach einer Beschädigung des genannten Gehäuseteiles dieses zu ersetzen.

Eine konkrete Ausbildung der Verbindung der beiden Gehäuseteile, die primär für die Verbindung von Sockel und Aufbau eines Kabelverteilerschrankes Verwendung findet, sieht vor, daß jedes Steckelement mit zwei Keilaufnahmen versehen ist, die mit zwei eine Baueinheit bildenden Arretierkeilen zusammenwirken. Die jeweiligen Keilaufnahmen sollten dabei als Einstecknasen ausgebildet sein, die auf ihrer dem jeweiligen Arretierkeil zugewandten Seite eine nach außen gerichtete Wölbung aufweisen. Zum dauerhaften Verbinden der beiden Gehäuseteile sollte dem Steckelement eine Rasteinrichtung zugeordnet sein, zum Arretieren des Steckelementes in dessen beiden Endstellungen, ferner sollte auch der Trägerplatte eine Rasteinrichtung zugeordnet sein, dort hingegen wegen des Zusammenwirkens von Keilaufnahme bzw. Keilaufnahmen mit Arretierkeil bzw. Arretierkeilen, zum Arretieren der Trägerplatte in jeder beliebigen Stellung. Die Rastung der Trägerplatte ermöglicht es, einen solchen Keilwinkel des bzw. der Arretierkeile vorzusehen, der unterhalb der Selbsthemmung liegt, womit eine Verbindung der beiden Gehäuseteile bei minimalem Verschiebeweg der Arretierkeile bzw. der Trägerplatte sichergestellt ist.

Konkret auf die Ausbildung der Gehäuseteile als Sockel und den Aufbau eines Kabelverteilerschrankes bezogen, sollte das Steckelement dem als Aufbau des Kabelverteilerschrankes ausgebildeten oberen Gehäuseteil und der Arretierkeil dem als Sockel ausgebildeten unteren Gehäuseteil des Schrankes zugeordnet sein. Der Sockel kann auf dem Erdboden aufstehen oder teilweise in das Erdreich eingegraben sein.

Weitere Merkmale der Erfindung sind in der Beschreibung der Figuren und in den Unteransprüchen dargestellt, wobei bemerkt wird, daß alle Einzelmerkmale und alle Kombinationen von Einzelmerkmalen erfindungswesentlich sind.

In den Figuren ist die erfindungsgemäße Verbindung zweier Gehäuseteile an einer Ausführungsform, nämlich einer Verbindung von Sockel und Aufbau eines Kabelverteilerschrankes dargestellt, ohne auf diese Ausführungsform beschränkt zu sein. Es stellt dar:
- Figur 1: eine Draufsicht des Sockels des Kabelverteilerschrankes,
- Figur 2: eine räumliche Ansicht eines Steckelementes,
- Figur 3: eine räumliche Darstellung eines Arretierelementes,
- Figur 4: eine räumliche Darstellung einer Abdeckplatte für das Arretierelement,
- Figur 5: eine Darstellung der Verbindung von Sockel und Aufbau des Kabelverteilerschrankes im Bereich einer Seitenwand, gezeigt in geöffneter Stellung von Steckelement und Arretierelement, ohne Abdeckplatte,
- Figur 6: eine Ansicht gemäß Figur 5, jedoch mit Steckelement und Arretierelement in geschlossener Stellung,
- Figur 7: eine Ansicht gemäß Figur 5 mit Abdeckplatte und
- Figur 8: eine Ansicht gemäß Figur 6 mit Abdeckplatte.

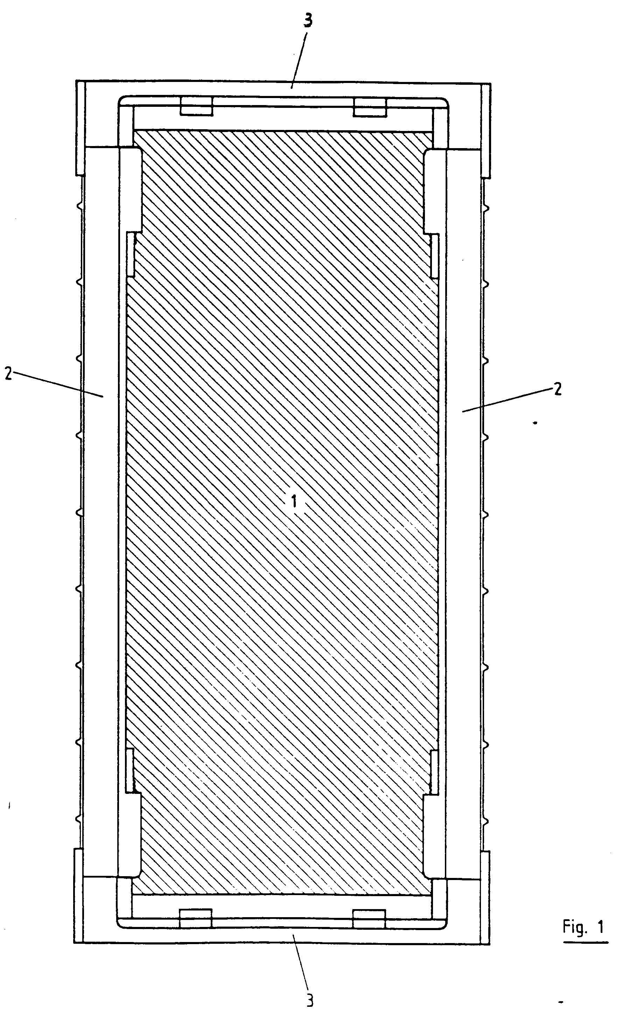

Der in der Figur 1 in Draufsicht gezeigte Sockel besteht im wesentlichen aus einem Boden 1, zwei, die Längswände des Sockels bildenden Wandsegmenten 2 sowie zwei die Stirnseiten jeweiliger Wandsegmente 2 verbindenden, die Querwände des Sockels bildenden Wandsegmenten 3. Der auf den Sockel aufsetzbare Aufbau besteht aus entsprechenden Längs- und Querwänden. Die schraffierte Fläche in Figur 1 verdeutlicht das lichte Einbaumaß des Sockels, das lichte Einbaumaß des Aufbaus entspricht diesem.

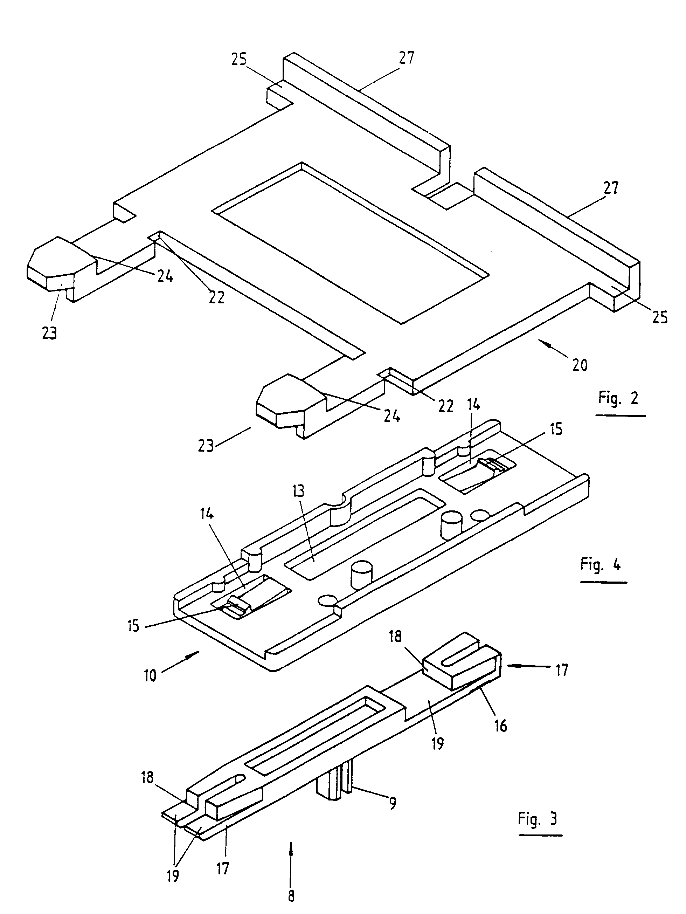

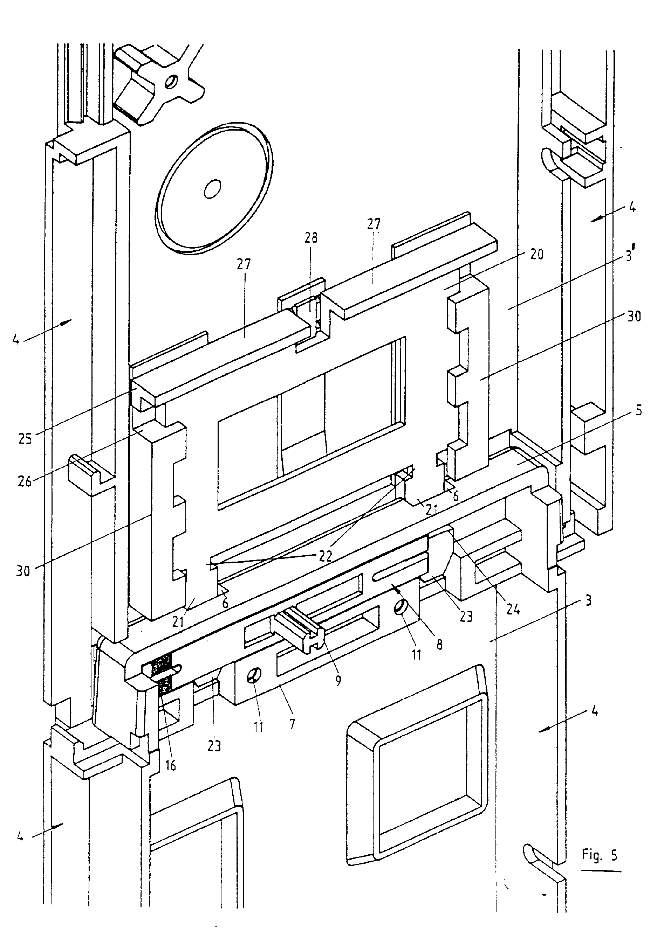

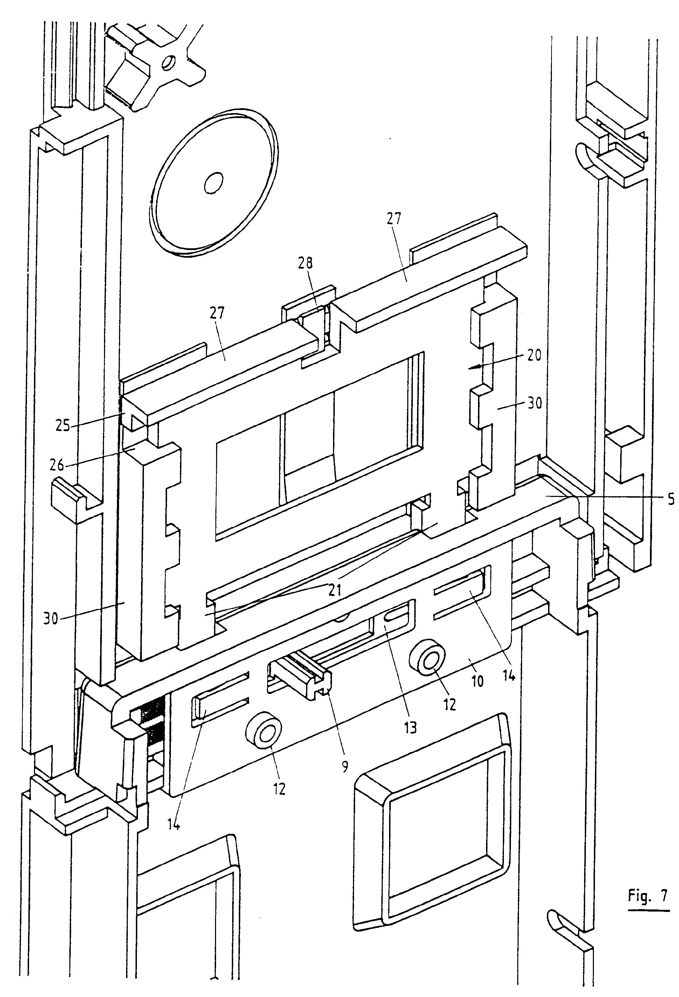

Sockel und Aufbau sind im Bereich der gegenüberliegenden, die Querwände bildenden Wandsegmente 3 mittels der erfindungsgemäßen Verbindung verbindbar. Die weiteren Figuren 2 bis 6 verdeutlichen den Verbindungsbereich einer Querwand sowie die Verwendung findenden Verbindungselemente.

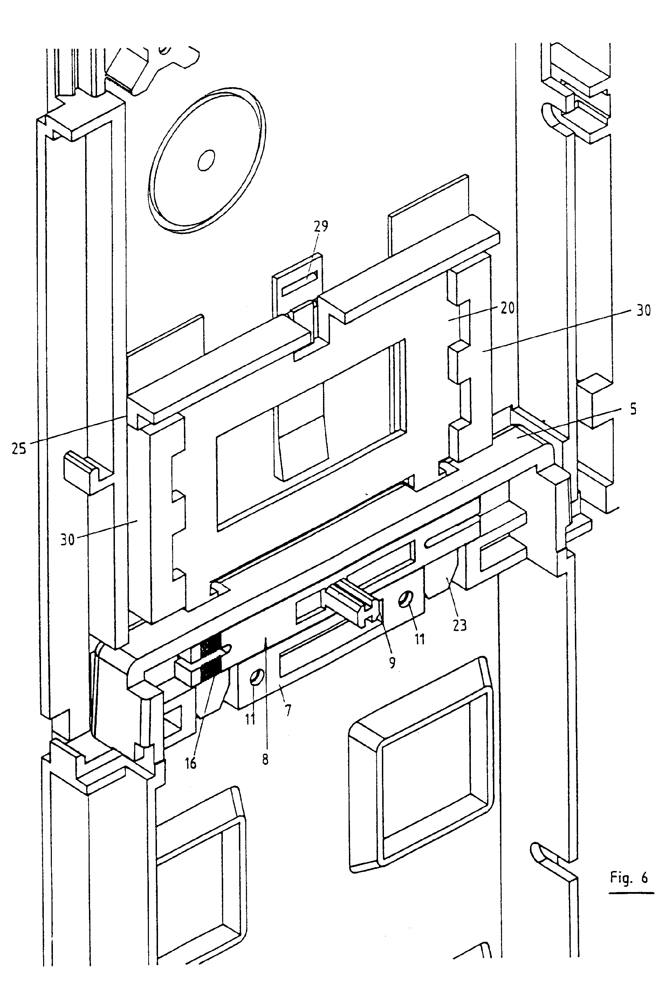

Die Figuren 5 bis 8 zeigen das eine Sockelwandsegment 3, auf das ein Aufbauwandsegment 3′ aufgesetzt ist. Nicht gezeigt sind in den Figuren die sich an die Wandsegmente 3 und 3′ anschließenden Längswandsegmente, es versteht sich von selbst, daß der komplette Aufbau - gegebenenfalls ohne Deckel - auf den kompletten Sockel aufgesetzt wird. Die einzelnen Segmente von Sockel bzw. Aufbau sind in deren Flanschbereichen 4 über Befestigungsmittel oder Rastelemente miteinander verbunden.

Das in den Figuren 5 bis 8 gezeigte Sockelwandsegment 3 weist auf seiner dem Aufbauwandsegment 3′ zugewandten Seite ein an das Sockelwandsegment 3 angeformtes, plattenförmiges, sich senkrecht zur Ebene des Sockelwandsegmentes 3 erstreckendes Lagerelement 5 auf. Dieses ist in seinen beiden Endbereichen jeweils mit einer dieses senkrecht durchsetzenden Ausnehmung 6 versehen. Parallel zum Lagerelement 5 ist in Abstand von diesem ein weiteres, gleichfalls plattenförmig ausgebildetes und an das Sockelwandsegment 3 angeformtes Lagerelement 7 vorgesehen. Die beiden Lagerelemente 5 und 7 nehmen zwischen sich ein im wesentlichen plattenförmig ausgebildetes Arretierelement 8 auf, das mit einem in das Innere des Kabelverteilerschrankes ragenden Betätigungszapfen 9 versehen ist. Das Arretierelement 8 kann damit zwischen den gegenüberliegenden Flanschbereichen 4 des Sockelwandsegmentes 3 hin- und hergeschoben werden, wobei es weitgehend spielfrei geführt ist. Zur sicheren Positionierung des Arretierelementes 8 dient eine mit dem Lagerelement 7 verschraubbare Abdeckplatte 10, die die dem Sockelwandsegment 3 abgewandte Seite des Arretierelementes 8 abdeckt. Befestigt wird die Abdeckplatte 10 mittels zweier nicht näher gezeigter Schrauben, verdeutlicht sind in den Figuren 5 bis 8 die beiden Gewindebohrungen 11 im Lagerelement 7 zur Aufnahme der Befestigungsschrauben und auf die Schrauben aufgesteckte Abdeckkappen 12.

Die Abdeckplatte 10 ist mit einem Längsschlitz 13 versehen, durch den der Betätigungszapfen 9 bei angeschraubter Abdeckplatte 10 in das Innere des Kabelverteilerschrankes ragt. Zu jeder Seite des Schlitzes 13 schließt sich eine ein Bestandteil der Abdeckplatte 10 bildende, als Lippe ausgebildete Druckfeder 14 an, deren freies Ende einen zum Arretierelement 7 gerichteten Rastansatz 15 aufweist. Eine der beiden Druckfedern 14 wirkt mit einer Riffelung 16 zusammen, die im Bereich des zugeordneten Endes des Arretierelementes 8 in dieses eingebracht ist. Die am Arretierelement 8 anliegenden Druckfedern 14 bewirken damit grundsätzlich eine spielfreie Lagerung des Arretierelementes zwischen dem Sockelwandsegment 3 und der Abdeckplatte 10, darüber hinaus bewirkt die eine Druckfeder im Zusammenwirken mit der Riffelung 16 eine Rastierung des Arretierelementes 8 in der jeweils eingenommenen Position.

Wie insbesondere der Darstellung der Figur 3 zu entnehmen ist, weist das Arretierelement 8 auf seiner dem Betätigungszapfen 9 abgewandten Seite im Bereich jedes Endes einen Arretierkeil 17 auf, wobei die Keilrichtungen der Arretierkeile 17 gleich sind.

An die Frontbereiche 18 der Arretierkeile 17 schließen sich jeweils hinterschnittene Bereiche 19 des Arretierelementes 8 an.

In geringem Abstand zu den Flanschbereichen 4 des Aufbauwandsegmentes 3′ ist parallel zu diesen jeweils eine Führungsleiste 30 angeordnet, in denen ein plattenförmiges Steckelement 20 parallel zum Aufbauwandsegment 3′ vertikal verschiebbar gelagert ist. Das Steckelement 20 weist unten beabstandet voneinander zwei Ansätze 21 mit verjüngten Verbindungsabschnitten 22 auf, denen die Funktion von Sollbruchstellen zukommt. Die den Verbindungsabschnitten 22 abgewandten Enden der Ansätze 21 sind als konisch zulaufende Einstecknasen 23 ausgebildet. Die den Sollbruchstellen zugewandten Seiten 24 der Einstecknasen 23 weisen eine nach außen, das heißt in Richtung der Sollbruchstellen gerichtete Wölbung auf. Der Abstand der beiden Einstecknasen 23 voneinander ist so bemessen, daß sie beim vertikalen Verschieben des Steckelementes 20 die Ausnehmungen 6 im Lagerelement 5 durchsetzen.

Das Steckelement 20 weist schließlich auf seiner den Einstecknasen 23 abgewandten Seite, somit oben, beidseitig einen Anschlag 25 auf, der in der unteren Endstellung in Anlage mit der oberen Fläche 26 der jeweiligen Führungsleisten 30 gelangt. Zum Handhaben des Steckelementes 20 dient eine oben an diesem angebrachte geteilte Grifflasche 27, die zwischen den Teilungsabschnitten ein mit dem Steckelement 20 verbundenes Rastelement 28 aufnimmt, das seinerseits in der oberen Endstellung des Steckelementes 20 mit einem korrespondierenden Rastabschnitt 29 des Aufbauwandsegmentes 3′ zusammenwirkt.

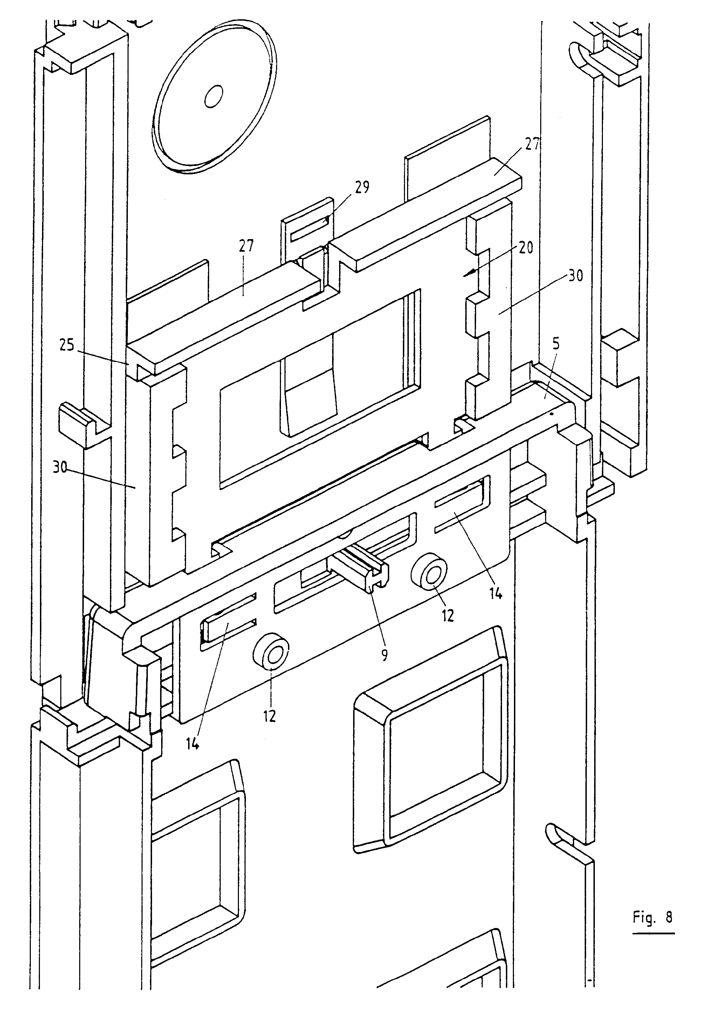

Der Aufbau läßt sich nun erfindungsgemäß besonders einfach auf dem Sockel montieren und mit diesem dauerhaft und sicher verbinden. In der Stellung gemäß der Figuren 5 und 7 wird der Aufbau auf den Sockel aufgesetzt, hierbei befindet sich das Steckelement 20 in seiner oberen rastierten Stellung und es ist das Arretierelement 8 nach links bewegt, in dieser rastierten Stellung fluchten dessen hinterschnittene Bereiche 19 mit den Ausnehmungen 6 und es durchsetzen die beiden Ansätze 21 des Steckelementes 20 und die diesen zugeordneten Einstecknasen 23 die beiden Ausnehmungen 6 sowie die hinterschnittenen Bereiche 19 des Arretierelementes 8. Es werden dann jeweils in den beiden Aufbauwandsegmenten 3′ geführte Steckelemente 20 aus der Rastierung heraus nach unten bewegt, wobei die Anschläge 25 in Anlage mit den oberen Flächen 26 gelangen. In dieser Position sind die Einstecknasen 23 so weit abgesenkt, daß sie gerade in den Bewegungsweg der Arretierkeile 17 ragen. Wird das Arretierelement 8 nun durch Betätigung des Betätigungszapfens 9 im Sinne der Darstellung der Figuren 5 bis 8 nach rechts verschoben, gelangen die Arretierkeile 17 in Anlage mit den nach außen gewölbten Seiten 24 der Einstecknasen 23 und verspannen das jeweilige Steckelement 20 zwischen den Führungsleisten 30 und den Arretierkeilen 17. Die Rastierung des Arretierelementes 8 gewährleistet die dauerhafte Verbindung von Sockel und Aufbau. Das Lösen von Sockel und Aufbau erfolgt in umgekehrtem Sinne.

### Bezugszeichenliste

- 1: Boden
- 2: Wandsegment
- 3: Sockelwandsegment
- 3′: Aufbauwandsegment
- 4: Flanschbereich
- 5: Lagerelement
- 6: Ausnehmung
- 7: Lagerelement
- 8: Arretierelement
- 9: Betätigungszapfen
- 10: Abdeckplatte
- 11: Gewindebohrung
- 12: Abdeckkappe
- 13: Längsschlitz
- 14: Druckfeder
- 15: Rastansatz
- 16: Riffelung
- 17: Arretierkeil
- 18: Frontbereich
- 19: hinterschnittener Bereich
- 29: Steckelement
- 21: Ansatz
- 22: Verbindungsabschnitt
- 23: Einstecknase
- 24: Seite
- 25: Anschlag
- 26: obere Fläche
- 27: Grifflasche
- 28: Rastelement
- 29: Rastabschnitt
- 30: Führungsleiste

## Patentansprüche

1. Verbindung zweier Gehäuseteile, insbesondere des Sockels eines Kabelverteilerschrankes mit dessen Aufbau, mit im Inneren der Gehäuseteile angeordneten Verbindungselementen, **dadurch gekennzeichnet**, daß die Verbindungselemente im wesentlichen aus einem in einem der Gehäuseteile (3′) gelagerten und in das andere Gehäuseteil (3) einsteckbaren Steckelement (20) mit mindestens einer Keilaufnahme (23), sowie mindestens einem im anderen Gehäuseteil (3) relativ zu dem Steckelement (20) verschiebbaren Arretierkeil, der in seiner arretierten Stellung die mindestens eine Keilaufnahme (23) hintergreift, bestehen.

2. Verbindung nach Anspruch 1, **dadurch gekennzeichnet**, daß jedes Gehäuseteil (3, 3′) im Bereich der gegenüberliegenden schmalseitigen Gehäusewandungen (3. 3′) mit Steckelement (20) bzw. Arretierkeil (17) versehen ist.

3. Verbindung nach Anspruch 1 oder 2, **dadurch gekennzeichnet**, daß das Steckelement (20) in einer Gehäusewandung (3′) des einen Gehäuseteils in der Wandungsebene in Richtung des anderen Gehäuseteils in Führungen (30) verschiebbar gelagert ist und auf seiner, dem anderen Gehäuseteil zugewandten Seite mit der mindestens einen Keilaufnahme (23) versehen ist, und daß der Arretierkeil (17) in der angrenzenden Gehäusewandung (3) des anderen Gehäuseteils in der Wandungsebene senkrecht zur Bewegungsrichtung des Steckelements (20) in Führungen (5, 7) verschiebbar gelagert ist.

4. Verbindung nach Anspruch 3, **dadurch gekennzeichnet**, daß die mindestens eine Keilaufnahme (23) in einer ersten Endstellung des Steckelements (20) sich außerhalb des Bewegungsweges des zugeordneten Arretierkeiles (17) befindet und in einer zweiten Endstellung, bei Anlage des Steckelementes (20) an einem dessen Gehäuseteil (3′) zugeordneten Anschlag (26) sich im Bewegungsweg des zugeordneten Arretierkeiles (17) befindet.

5. Verbindung nach einem der Ansprüche 1 bis 4, **dadurch gekennzeichnet**, daß der mindestens eine Arretierkeil (17) von einer Trägerplatte (8) aufgenommen wird, die in Anlage mit der zugeordneten Wandung des Gehäuseteils (3) zwischen zwei sich in Verschieberichtung der Trägerplatte (8) seitlich zu dieser erstreckenden Lagerplatten (5, 7) gehalten ist.

6. Verbindung nach Anspruch 5, **dadurch gekennzeichnet**, daß die Lagerplatten (5, 7) Bestandteil des dem Arretierkeil (17) zugeordneten Gehäuseteils (3) bilden und die dem Steckelement (20) zugewandte Lagerplatte (5) mindestens eine Ausnehmung (6) zur Aufnahme der mindestens einen Keilaufnahme (23) des Steckelements (20) aufweist.

7. Verbindung nach Anspruch 5 oder 6, **dadurch gekennzeichnet**, daß eine Abdeckplatte (10) für die Trägerplatte (8) vorgesehen ist, die mit dem der Trägerplatte (8) zugeordneten Gehäuseteil (3) oder einer oder beiden Lagerplatten (5, 7) verbunden ist, wobei die Abdeckplatte (10) in Verschieberichtung der Trägerplatte (8) mit einer schlitzförmigen Ausnehmung (13) versehen ist, die ein mit der Trägerplatte (8) verbundener Betätigungszapfen (9) durchsetzt.

8. Verbindung nach einem der Ansprüche 1 bis 7, **dadurch gekennzeichnet**, daß das Steckelement (20) auf seiner der mindestens einen Keilaufnahme (23) abgewandten Seite mit einem Griffflansch (27) versehen ist.

9. Verbindung nach einem der Ansprüche 4 bis 8, **dadurch gekennzeichnet**, daß das Steckelement (20) zwischen seinem mit dem Anschlag (26) in Anlage gelangenden Bereich und der mindestens einen Keilaufnahme (23) mit einer Sollbruchstelle (22) versehen ist.

10. Verbindung nach einem der Ansprüche 1 bis 9, **dadurch gekennzeichnet**, daß jedes Steckelement (20) mit zwei Keilaufnahmen (23) versehen ist, die mit zwei eine Baueinheit bildenden Arretierkeilen (17) zusammenwirken.

11. Verbindung nach einem der Ansprüche 1 bis 10, **dadurch gekennzeichnet**, daß die jeweilige Keilaufnahme (23) als Einstecknase ausgebildet ist, die auf ihrer dem jeweiligen Arretierkeil (17) zugewandten Seite eine nach außen gerichte Wölbung (24) aufweist.

12. Verbindung nach einem der Ansprüche 1 bis 11, **dadurch gekennzeichnet,** daß dem Steckelement (20) eine Rasteinrichtung (28, 29) zugeordnet ist, zum Arretieren des Steckelements in dessen oberer Endstellung.

13. Verbindung nach einem der Ansprüche 1 bis 12, **dadurch gekennzeichnet**, daß der Trägerplatte (8) eine Rasteinrichtung (15, 16) zugeordnet ist, zum Arretieren der Trägerplatte (8) in jeder beliebigen Stellung.

## Claims

1. A connection for two housing parts, particularly for the base of a cable terminal cubicle with its body, having connection elements disposed inside the housing parts, characterised in that the connection elements essentially consist of a plug-in element (20) which is mounted in one of the housing parts (3′), which can be plugged into the other housing part (3), and which has at least one wedge receiver (23), and of at least one locking wedge which is displaceable in the other housing part (3) in relation to the plug-in element (20) and which in its locked position engages behind the at least one wedge receiver (23).

2. A connection according to claim 1, characterised in that each housing part (3, 3′) is provided with a plug-in element (20) or locking wedge (17) in the region of the opposite narrow housing walls (3, 3′)

3. A connection according to claim 1 or 2, characterised in that the plug-in element (20) is mounted in guides (30) in a housing wall (3′) of one housing part, in the plane of the wall so that it is displaceable in the direction of the other housing part, and is provided on its side facing the other housing part with the at least one wedge receiver (23), and that the locking wedge (17) is mounted in guides (5, 7) in the adjoining housing wall (3) of the other housing part, in the plane of the wall so that it is displaceable perpendicular to the direction of movement of the plug-in element (20).

4. A connection according to claim 3, characterised in that in a first end position of the plug-in element (20) the at least one wedge receiver (23) is situated outside the path of movement of the associated locking wedge (17) and in a second end position, when there is contact of the plug-in element (20) with a stop (26) associated with its housing part (3′), the wedge receiver is situated within the path of movement of the associated locking wedge (17).

5. A connection according to any one of claims 1 to 4, characterised in that the at least one locking wedge (17) is received by a support plate (8) which is held in contact with the associated wall of the housing part (3) between two bearing plates (5, 7) extending in the direction of displacement of the support plate (8) at the sides of the latter.

6. A connection according to claim 5, characterised in that the bearing plates (5, 7) form a component of the housing part (3) associated with the locking wedge (17), and the bearing plate (5) facing the plug-in element (20) has at least one recess (6) for receiving the at least one wedge receiver (23) of the plug-in element (20).

7. A connection according to claim 5 or 6, characterised in that a cover plate (10) is provided for the support plate (8), which is attached to the housing part (3) associated with the support plate (8) or to one or both bearing plates (5, 7), wherein the cover plate (10) is provided with a recess (13) which is slot-shaped in the direction of displacement of the support plate (8) and which an operating peg (9) attached to the support plate (8) passes through.

8. A connection according to any one of claims 1 to 7, characterised in that the plug-in element (20) is provided with a gripping flange (27) on its side remote from the at least one wedge receiver (23).

9. A connection according to any one of claims 4 to 8, characterised in that the plug-in element (20) is provided with a predetermined breaking point (22) between its region which comes into contact with the stop (26) and the at least one wedge receiver (23).

10. A connection according to any one of claims 1 to 9, characterised in that each plug-in element (20) is provided with two wedge receivers (23) which cooperate with two locking wedges (17) which form a structural unit.

11. A connection according to any one of claims 1 to 10, characterised in that the respective wedge receiver (23) is formed as a plug-in projection which has an outwardly oriented curvature (24) on its side facing the respective locking wedge (17).

12. A connection according to any one of claims 1 to 11, characterised in that a locking device (28, 29) for locking the plug-in element in its upper end position is associated with the plug-in element (20).

13. A connection according to any one of claims 1 to 12, characterised in that a locking device (15, 16) for locking the support plate (8) in any desired position is associated with the support plate (8).

## Revendications

1. Dispositif de liaison de deux pièces d'armoire, en particulier du socle d'une armoire de distribution de câbles avec sa structure, au moyen d'éléments de liaison disposés à l'intérieur des pièces d'armoire, caractérisé en ce que les éléments de liaison se composent essentiellement d'un élément enfichable (20) monté dans une des pièces (3′) d'armoire et enfichable dans l'autre pièce (3) de l'armoire, élément comportant au moins une partie d'insertion en coin (23) ainsi qu'au moins une cale de blocage pouvant coulisser dans l'autre pièce d'armoire (3) par rapport à l'élément enfichable (20), pièce qui dans sa position d'arrêt saisit par derrière au moins une partie d'insertion en coin (23).

2. Dispositif de liaison selon la revendication 1, caractérisé en ce que chaque pièce d'armoire (3, 3′) est munie au niveau des parois d'armoire (3, 3′) des faces étroites opposées, d'un élément enfichable (20) ou d'une cale de blocage (17).

3. Dispositif de liaison selon les revendications 1 ou 2, caractérisé en ce que l'élément enfichable (20) est logé dans une paroi d'armoire (3′) d'une des pièces d'armoire et est mobile dans des glissières de guidage (30) dans le plan de la paroi en direction de l'autre pièce d'armoire et il est muni sur son côté tourné vers l'autre pièce d'armoire d'au moins une partie d'insertion en coin (23), et en ce que la cale de blocage (17) est logée dans la paroi d'armoire (3) contiguë de l'autre pièce d'armoire et elle est mobile dans le plan de paroi dans des glissières de guidage (5, 7) perpendiculairement au sens du mouvement de l'élément enfichable (20).

4. Dispositif de liaison selon la revendication 3, caractérisé en ce que l'une au moins des parties d'insertion en coin (23) se trouve dans une première position extrême de l'élément enfichable (20) en dehors du chemin de déplacement de la cale de blocage (17) associée et dans une deuxième position extrême, lors du positionnement de l'élément enfichable (20) contre une butée (26) associée à sa pièce de boîtier (3′), elle se trouve dans le chemin de déplacement de la cale de blocage (17) associée.

5. Dispositif de liaison selon une des revendications 1 à 4, caractérisé en ce que l'une au moins des cales de blocage (17) est engagée par une plaque support (8), qui est maintenue en position avec la paroi associée de la pièce d'armoire (3) entre deux plaques d'appui (5, 7) s'étendant dans le sens de déplacement de la plaque support (8) latéralement par rapport à celle-ci.

6. Dispositif de liaison selon la revendication 5, caractérisé en ce que les plaques d'appui (5, 7) forment une pièce stable de la pièce d'armoire (3) associée à la cale de blocage (17) et la plaque d'appui (5) tournée vers l'élément enfichable (20) comporte au moins un évidement (6) pour recevoir au moins une partie d'insertion en coin (23) de l'élément enfichable (20).

7. Dispositif de liaison selon les revendications 5 ou 6, caractérisé en ce qu'une plaque de recouvrement (10) est prévue pour la plaque support (8), qui est liée avec la pièce d'armoire (3) associée à la plaque support (8) ou à l'une ou aux deux plaques d'appui (5, 7), la plaque de recouvrement (10) étant munie dans le sens du déplacement de la plaque support (8), d'un évidement (13) en forme de rainure, que traverse un tenon de commande (9) lié à la plaque support (8).

8. Dispositif de liaison selon une des revendications 1 à 7, caractérisé en ce que l'élément enfichable (20) est muni d'un collet de manipulation (27) au moins sur son côté éloigné de la partie d'insertion en coin (23).

9. Dispositif de liaison selon une des revendications 4 à 8, caractérisé en ce que l'élément enfichable (20) est muni d'un point destiné à la rupture entre sa zone qui parvient en position d'appui contre la butée (26) et au moins l'une des parties d'insertion en coin (23).

10. Dispositif de liaison selon une des revendications 1 à 9, caractérisé en ce que chaque élément enfichable (20) est muni de deux parties d'insertion en coin (23) qui coopèrent avec deux cales de blocage (17) formant une unité de construction.

11. Dispositif de liaison selon une des revendications 1 à 10, caractérisé en ce que la partie d'insertion en coin respective (23) est réalisée comme un taquet enfichable, qui comporte sur sa face tournée vers la cale de blocage (17) respective une moulure (24) concave dirigée vers l'extérieur.

12. Dispositif de liaison selon une des revendications 1 à 11, caractérisé en ce qu'à l'élément enfichable (20) est associé un dispositif à encoches (28, 29), pour bloquer l'élément enfichable dans sa position extrême supérieure.

13. Dispositif de liaison selon une des revendications 1 à 12, caractérisé en ce qu'à la plaque de support (8) est associé un dispositif à crans (15, 16) pour bloquer la plaque support (8) dans chaque position au choix.
